# FASCICULE DE BREVET EUROPEEN

(11) **EP 3 268 754 B1**
(45) Date de publication et mention de la délivrance du brevet: **27.04.2022**
(21) Numéro de dépôt: 16712742.2
(22) Date de dépôt: 09.03.2016
(51) Int. Cl.: G01R 15/18

(54) **CAPTEUR DE COURANT POUR MESURER UN COURANT ALTERNATIF**
STROMSENSOR ZUR MESSUNG EINES WECHSELSTROMS
CURRENT SENSOR FOR MEASURING AN ALTERNATING CURRENT

(30) Priorité: 10.03.2015 FR 1551984
(43) Date de publication de la demande: 17.01.2018
(73) Titulaire: Socomec, 67230 Benfeld (FR)
(72) Inventeur: KERN, Christian, 68240 Sigolsheim (FR)
(74) Mandataire: Koelbel, Caroline
(86) Numéro de dépôt international: PCT/EP2016/055060
(87) Numéro de publication internationale: WO 2016/142439

(56) Documents cités:
- WO-A1-2013/037986
- DE-A1-102007 046 054
- US-A1- 2008 106 253
- US-A1- 2014 167 786

## Description

### Domaine technique :

La présente invention concerne un capteur de courant pour mesurer un courant alternatif, ledit capteur comportant au moins une bobine électrique réalisée sous la forme d'un circuit imprimé prévu sur au moins une carte électronique, une unité électronique de conditionnement du signal de ladite bobine électrique et un bornier de raccordement électrique, ladite bobine électrique ayant un contour fermé s'inscrivant dans un polygone et délimitant en son centre une fenêtre de passage pour un conducteur électrique traversé par le courant alternatif à mesurer, ce conducteur étant appelé conducteur primaire, ladite bobine électrique comportant N tronçons rectilignes de largeur L et N secteurs circulaires de même largeur L délimités chacun par un arc intérieur de rayon intérieur Ri et un arc extérieur de rayon extérieur Re, lesdits tronçons rectilignes étant reliés deux à deux par un secteur circulaire, lesdits tronçons rectilignes étant constitués de spires séparées entre elles d'un pas constant P, et lesdits secteurs circulaires étant constitués de spires séparées entre elles sur ledit arc intérieur d'un pas constant égal au pas P et sur ledit arc extérieur d'un pas constant supérieur au pas P.

### Technique antérieure :

La mesure des courants alternatifs s'effectue à l'aide de capteurs de courant basés sur des principes de fonctionnement différents. Une des technologies bien connue et largement exploitée pour les applications industrielles repose sur le principe de Rogowski. Ce principe consiste en un bobinage dans l'air placé autour d'un conducteur électrique traversé par le courant alternatif à mesurer, appelé communément un conducteur primaire. Ce bobinage peut être formé d'une ou de plusieurs bobines électriques raccordées en série. Les avantages de ce type de capteur de courant résident dans sa grande linéarité et dans une dynamique de mesure étendue, autorisant la mesure des courants s'échelonnant de quelques centaines de milliampères à quelques milliers d'ampères, à des fréquences à partir de quelques dizaines de hertz. Ces avantages sont principalement dus à l'absence de noyau magnétique à saturer. Néanmoins, la réalisation industrielle par les techniques classiques d'enroulement des bobines de Rogowski de bonne qualité est très complexe, onéreuse et difficilement reproductible, car ces bobines nécessitent une densité linéique de spires constante ainsi qu'une section de spires constante. Plusieurs exemples de réalisation sont illustrés dans la publication WO 2013/037986.

La solution consiste à réaliser les bobines de Rogowski sous la forme de circuit imprimé. Cette technologie permet en effet d'obtenir une grande précision du tracé du bobinage et une reproductibilité industrielle particulièrement adaptées au respect de la régularité du bobinage. Néanmoins, les bobines de Rogowski obtenues par cette technologie de circuit imprimé ont une sensibilité de mesure faible, par exemple de l'ordre 10µV/A pour un courant à mesurer d'une fréquence 50Hz, étant donné que la densité des spires est faible, de l'ordre de 1 à 1,2 spires par mm pour les technologies classiques de circuits imprimés, et que les spires ne peuvent pas être superposées.

Le plus souvent les bobines de Rogowski sont circulaires, comme celles décrites par exemple dans les publications FR 2 845 197, DE 10 2007 046 054 et US 2008/0106253. L'utilisation de bobines polygonales, comme celles décrites par exemple dans les publications EP 1 923 709 et US 2014/0167786, pose en effet des problèmes de régularité de bobinage dans les angles et affecte la qualité de la bobine.

La sensibilité du capteur de courant varie alors en fonction de la position relative du conducteur primaire dans la fenêtre de passage délimitée par le capteur de courant. Les irrégularités du bobinage dans les angles de la bobine entrainent également une moins bonne immunité aux champs magnétiques externes, en particulier ceux qui pourraient être créés par un conducteur primaire voisin, positionné à proximité de la bobine, ce qui est toujours le cas dans les installations industrielles visées. En effet, il y a en général trois conducteurs de phases proches, séparés par un entraxe qui est souvent du même ordre de grandeur que les dimensions des conducteurs. A titre d'exemple, si les conducteurs primaires sont constitués de barres de 63mm de large et que ces barres sont séparées d'un entraxe de 85mm, l'espace libre entre deux barres consécutives est égal à 22mm. Par ailleurs, lorsqu'on est en présence de forts courants, il est fréquent d'utiliser plusieurs barres rectangulaires parallèles entre elles pour chaque phase. Ainsi, la section de passage pour chaque phase présente nécessairement une forme rectangulaire. L'utilisation de bobines circulaires conduit par conséquent à un encombrement du capteur de courant beaucoup plus important qu'avec des bobines rectangulaires, au point parfois de rendre impossible la mise en place du capteur de courant du fait de la proximité des conducteurs primaires des autres phases.

La publication WO 2013/037986 propose d'ajouter dans les secteurs circulaires de ses bobines polygonales des spires additionnelles pour corriger en partie les défauts introduits par la présence de coins dans ces bobines polygonales. Mais cette solution n'est pas optimale en termes de sensibilité. En effet, cette publication propose de découper chaque secteur circulaire de la bobine en au moins deux bandes théoriques adjacentes par ajout de spires additionnelles de largeur inférieure à la largeur totale de la bobine, pour créer dans chacune des bandes théoriques une densité moyenne de spires sensiblement égale à celle du tronçon rectiligne correspondant. Du fait de ce mode de construction de la bobine, le pas entre deux spires consécutives n'est pas égal sur l'arc intérieur et sur l'arc extérieur de la bobine, pour une même densité moyenne de spires, ce pas est réduit sur l'arc intérieur de la bande théorique intérieure d'un secteur circulaire alors qu'il est plus grand dans le tronçon rectiligne correspondant, générant une densité moyenne de spires dans les tronçons rectilignes forcément inférieure à la densité moyenne de spires dans une zone proche du bord intérieur des secteurs circulaires. Or la sensibilité d'un tel capteur de courant est majoritairement déterminée par la densité de spires dans ses tronçons rectilignes, qui dans ce cas est insuffisante, impactant négativement la précision de la mesure.

Ces solutions existantes ne sont donc pas satisfaisantes.

### Exposé de l'invention :

La présente invention vise à résoudre ce problème en proposant une nouvelle conception des bobines de type Rogowski pour capteur de courant, ces bobines étant réalisées sous la forme de circuit imprimé, présentant une forme sensiblement polygonales, dont la sensibilité de mesure est maximisée tout en garantissant une bonne immunité aux variations de position du conducteur primaire par rapport au capteur de courant, ainsi qu'une bonne immunité aux courants traversant les conducteurs primaires voisins, comparables à celles des bobines circulaires de technologie similaires, et offrant un encombrement réduit permettant l'installation des capteurs de courant sur des conducteurs primaires très proches les uns des autres ainsi qu'une facilité d'intégration dans toute configuration d'appareils de mesure.

Dans ce but, l'invention concerne un capteur de courant selon la revendication 1.

Ainsi, la régularité du pas P entre spires, aussi bien sur le pourtour intérieur que sur le pourtour extérieur de la bobine électrique, et la régularité de la densité moyenne de spires dans toute la largeur de la bobine électrique, aussi bien dans les tronçons rectilignes que dans les secteurs circulaires, permettent à la fois de maximiser la sensibilité de mesure du capteur de mesure et de minimiser la sensibilité du capteur de mesure à la position du conducteur primaire et à la présence de conducteurs voisins.

Dans une première variante de réalisation, la bobine électrique peut comporter, dans ses secteurs circulaires, des premières spires additionnelles de largeur s'étendant dudit arc extérieur vers respectivement un premier arc intermédiaire disposé entre ledit arc intérieur et ledit arc extérieur.

Dans une seconde variante de réalisation, la bobine électrique peut comporter, dans ses secteurs circulaires, des premières spires additionnelles et des secondes spires additionnelles de largeurs respectives différentes s'étendant dudit arc extérieur vers respectivement un premier arc intermédiaire et un second arc intermédiaire disposés entre ledit arc intérieur et ledit arc extérieur.

Dans une forme préférée de l'invention, la bobine électrique est réalisée sous la forme d'un circuit imprimé comportant au moins une première couche conductrice et une deuxième couche conductrice, superposées, séparées entre elles par un cœur isolant d'un substrat de ladite carte électronique, lesdites première et deuxième couches conductrices étant connectées entre elles par des trous de liaison traversant ledit substrat pour former les spires de ladite bobine électrique.

Le capteur de courant peut comporter un conducteur de retour présentant une surface plane sensiblement égale à celle de ladite bobine électrique pour annuler des champs parasites, ledit conducteur de retour étant réalisé sous la forme d'un circuit imprimé comportant au moins une troisième couche conductrice, superposée à ladite bobine électrique et séparée d'elle par une couche isolante dudit substrat, ledit conducteur de retour étant connecté en série à ladite bobine électrique par des trous de liaison traversant ledit substrat.

Dans la forme de réalisation préférée, le capteur de courant comporte deux bobines électriques réalisées sous la forme d'un circuit imprimé comportant au moins quatre couches conductrices, lesdites bobines électriques étant identiques, opposées, superposées, séparées entre elles par une couche centrale isolante du substrat, et connectées en série par des trous de liaison traversant ledit substrat.

Ce capteur de courant selon l'invention peut avantageusement comporter un blindage électrique, comportant au moins une couche conductrice supérieure externe et une couche conductrice inférieure externe recouvrant ladite bobine électrique et son conducteur de retour, ou lesdites bobines électriques, et séparées de la ou des bobines électriques et/ou du conducteur de retour par une couche isolante additionnelle dudit substrat.

Le blindage électrique peut comporter en outre au moins une couche conductrice latérale recouvrant la tranche dudit substrat, ainsi qu'un boîtier conducteur disposé autour de ladite unité électronique de conditionnement.

Dans une autre forme de réalisation, le capteur de courant selon l'invention peut comporter un circuit de mesure de tension agencé pour mesurer la tension appliquée au conducteur primaire. Ce circuit de mesure de tension peut comporter au moins une électrode de détection entourant la fenêtre de passage prévue dans ladite bobine électrique, ladite électrode de détection étant raccordée à un potentiel de référence par un circuit RC et étant constituée d'au moins une couche conductrice latérale recouvrant la tranche du substrat entourant ladite fenêtre de passage.

Selon l'application considérée, le capteur de courant peut être monophasé et comporter une fenêtre de passage pour un conducteur primaire, ladite fenêtre de passage étant entourée d'au moins une bobine électrique, ou être polyphasé et comporter N fenêtres de passage pour N conducteurs primaires, chaque fenêtre de passage étant entourée d'au moins une bobine électrique.

Le capteur de courant peut ne comporter qu'une seule carte électronique, pourvue de N fenêtres de passage, les bobines électriques correspondantes étant disposées sur ladite carte électronique. Il peut également comporter au moins deux cartes électroniques superposées, comportant chacune N fenêtres de passage, lesdites bobines électriques correspondantes étant réparties alternativement sur lesdites cartes électroniques.

Dans ce cas, l'unité électronique de conditionnement associée à chaque bobine électrique peut être avantageusement disposée entre les deux cartes électroniques, formant intrinsèquement un blindage électrique protégeant les unités électroniques de conditionnement, ce qui permet de supprimer le boitier conducteur formant blindage indispensable dans un capteur de courant ne comprenant qu'une seule carte électronique

### Description sommaire des dessins :

La présente invention et ses avantages apparaîtront mieux dans la description suivante de plusieurs modes de réalisation donnés à titre d'exemple non limitatif, en référence aux dessins annexés, dans lesquels:
- la figure 1 est une vue en perspective d'un capteur de courant monophasé selon l'invention disposé autour d'un conducteur primaire,
- la figure 2 est une vue de dessus d'une bobine électrique appartenant au capteur de courant de la figure 1,
- la figure 3 est une vue en perspective d'un secteur circulaire du bobinage correspondant à la bobine électrique de la figure 2,
- la figure 4 est une vue de dessus d'une variante de réalisation de la bobine électrique de la figure 2,
- la figure 5 est une section agrandie d'un substrat de circuit imprimé du capteur de courant de la figure 1,
- la figure 6 est une section agrandie d'une variante de réalisation du substrat de la figure 5,
- les figures 7A et 7B sont respectivement une vue de face et une vue de côté d'un capteur de courant polyphasé, et
- la figure 8 est une vue similaire à la figure 6 d'une autre variante de réalisation du circuit imprimé du capteur de courant de la figure 1 ajoutant une fonction de mesure de tension.

### Illustrations de l'invention et différentes manières de la réaliser :

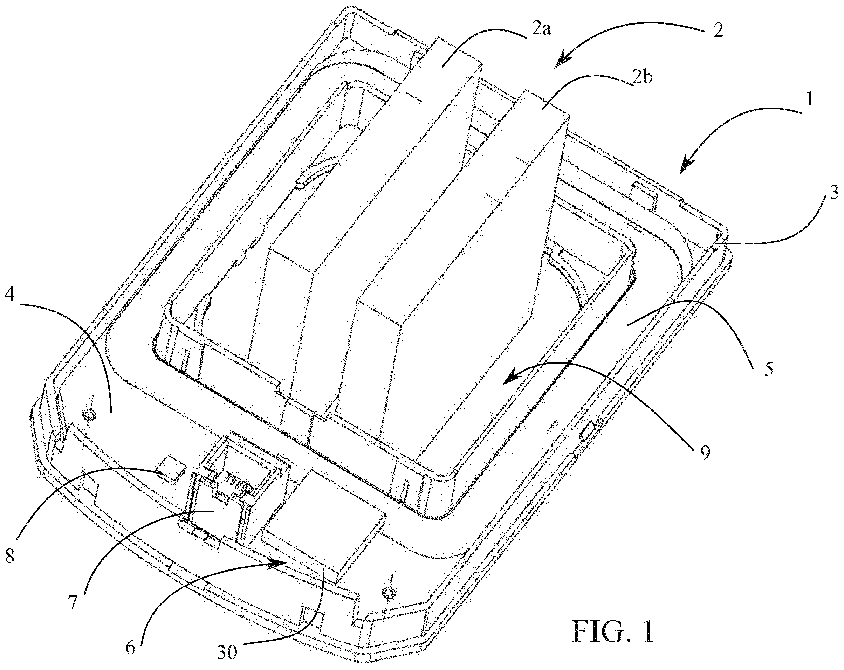

En référence à la figure 1, le capteur de courant 1 est un capteur monophasé destiné à mesurer un courant alternatif traversant un conducteur électrique. Ce conducteur électrique correspond à une phase d'une installation électrique et est appelé communément un conducteur primaire. Dans l'exemple représenté, le conducteur primaire 2 est constitué de deux barres conductrices 2a, 2b ayant chacune la forme d'un parallélépipède rectangle, et étant parallèles entre elles. Cet exemple n'est pas limitatif. Le conducteur primaire 2 peut être constitué d'une seule barre conductrice, de section carrée ou rectangulaire, de plus de deux barres conductrices parallèles, d'un câble conducteur ou d'un faisceau de câbles conducteurs, de section circulaire, ou tout autre type de conducteur connu, quelle que soit sa section. La composition et la section du conducteur primaire sont déterminées par le courant alternatif qu'il doit véhiculer.

Ce capteur de courant 1 comporte un boîtier 3 dont seule la partie inférieure est représentée pour montrer l'intérieur du capteur de courant 1. Ce boîtier 3 renferme une carte électronique 4 portant au moins une bobine électrique 5 réalisée sous la forme d'un circuit imprimé, une unité électronique de conditionnement 6 du signal de la bobine électrique 5, appelée communément un intégrateur, et un bornier de raccordement électrique 7 pour connecter le capteur de courant 1 à des périphériques, tels qu'à titre d'exemple une centrale de supervision des paramètres de l'installation électrique. Le capteur de courant 1 peut faire partie intégrante d'un appareil de mesure ou être indépendant et rapporté directement sur le conducteur primaire 2. Des exemples d'application sont par exemple décrits dans les publications WO 2015/150670 A1 et WO 2015/150671 A1 du même demandeur.

Dans l'exemple représenté, la carte électronique 4 comporte, en outre, une unité mémoire 8 dans laquelle sont enregistrées les données de calibration du capteur de courant 1. La composition du capteur de courant 1 telle que décrite et illustrée peut bien entendu variée en fonction des besoins, de la configuration de l'installation électrique à surveiller et des appareils de mesure et/ou de supervision. Les unités 6 et 8 ainsi que le bornier 7 sont intégrés à la carte électronique 4 portant la bobine électrique 5 mais peuvent être séparés et raccordés à la bobine électrique 5 par tout système de connexion adapté.

Dans l'exemple illustré, la bobine électrique 5 a un contour fermé s'inscrivant dans un polygone qui est ici rectangulaire. Ce contour sensiblement polygonal à angles arrondis a l'avantage d'être moins encombrant qu'un contour circulaire, surtout lorsque le conducteur primaire 2 est polygonal. La bobine électrique 5 délimite en son centre une fenêtre de passage 9, de contour également sensiblement polygonal, traversée par le conducteur primaire 2 positionné de préférence dans la partie centrale de la fenêtre de passage 9 et perpendiculairement au plan de la bobine électrique 5. Toutefois, les caractéristiques constructives de la bobine électrique 5 qui sont décrites plus loin permettent de rendre le capteur de courant 1 insensible à la position relative du conducteur primaire 2 par rapport à la bobine électrique 5, et à la proximité des conducteurs primaires voisins, ainsi qu'aux champs parasites induits si le conducteur primaire 2 n'est pas perpendiculaire au plan de la bobine électrique 5.

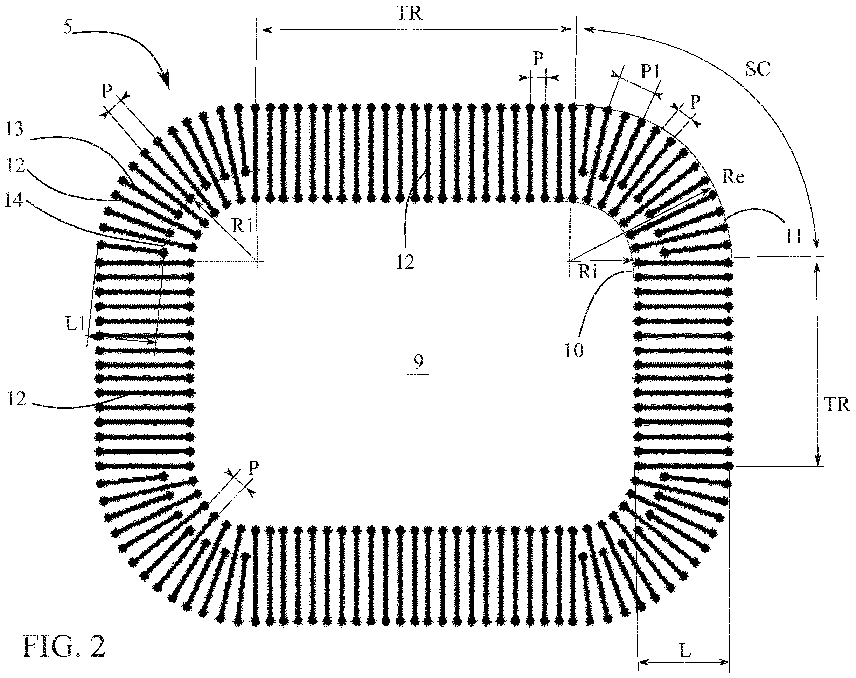

En référence plus particulièrement à la figure 2, la bobine électrique 5 comporte N tronçons rectilignes TR de largeur L et N secteurs circulaires SC de même largeur L, les tronçons rectilignes TR étant reliés deux à deux par un secteur circulaire SC. Dans les figures, le nombre N de tronçons rectilignes TR et de secteurs circulaire SC est égal à quatre puisque le polygone dans lequel s'inscrit la bobine électrique 5 est un rectangle. C'est exemple n'est pas limitatif et le nombre N de tronçons rectilignes TR et de secteurs circulaires SC peut être supérieur ou inférieur à quatre. Chaque secteur circulaire SC est délimité par un arc intérieur 10 de rayon intérieur Ri et un arc extérieur 11 de rayon extérieur Re où Re=Ri+L. Les tronçons rectilignes TR sont constitués de spires 12 régulièrement séparées d'un pas constant P, et les secteurs circulaires SC sont constitués de spires 12 séparées sur l'arc intérieur 10 d'un pas constant égal au pas P et sur l'arc extérieur 11 d'un pas constant P1 supérieur au pas P. En effet, elles sont séparées entre elles d'un angle dépendant du pas P et du rayon intérieur Ri. Dans la figure 2, le pas P1 est sensiblement égal à 2P.

Le fait de maintenir un pas P constant entre deux spires 12 consécutives sur le bord intérieur de la bobine électrique 5, aussi bien dans ses tronçons rectilignes TR que dans ses secteurs circulaires SC, permet de garantir une densité de spires constante dans la zone proche de ce bord intérieur, qui apporte un avantage indéniable du point de vue de l'immunité de la mesure aux variations de position du conducteur primaire 2 par rapport à la bobine électrique 5. En effet, quand un conducteur primaire 2 se rapproche des secteurs circulaires SC de la bobine électrique 5, dans lesquels la densité de spires ne peut pas être constante sur toute la largeur de la bobine, il est particulièrement important de maintenir cette densité de spires constante dans la zone proche du bord intérieur, là où les gradients de champ magnétique sont les plus forts, puisque ce sont dans cette zone que les mauvaises approximations de l'intégrale d'Ampère auront le plus d'influence.

Dans l'exemple de la figure 2, la bobine électrique 5 comporte, dans ses secteurs circulaires SC, des premières spires additionnelles 13 de largeur L1 inférieure à la largeur L des autres spires 12, appelées les spires principales 12. Ces premières spires additionnelles 13 s'étendent de l'arc extérieur 11 vers un premier arc intermédiaire 14 de rayon R1 disposé entre l'arc intérieur 10 et l'arc extérieur 11. Elles sont intercalées entre les spires principales 12 de telle sorte qu'une spire additionnelle 13 est positionnée entre deux spires principales 12 ramenant le pas entre deux spires 12, 13 consécutives sur l'arc extérieur 11 sensiblement égal au pas P. Ainsi, la densité moyenne de spires 12, 13 dans les secteurs circulaires SC est sensiblement égale à la densité de spires 12 dans les tronçons rectilignes TR. La densité moyenne de spires est la valeur moyenne prise sur toute la largeur L de la bobine électrique 5 du nombre de spires par unité de longueur. Le fait de ramener le pas entre deux spires 12, 13 consécutives sur l'arc extérieur 11 sensiblement égal au pas P entre deux spires 12 consécutives sur l'arc intérieur 10 apporte un avantage indéniable du point de vue de l'immunité de la mesure à la présence de conducteurs primaires externes et voisins de la bobine électrique 5 pour les mêmes raisons que celles exposées précédemment. Ainsi, la régularité du bobinage obtenue par l'invention permet de minimiser la variation de sensibilité du capteur de courant 1 en fonction de la position relative du conducteur primaire 2, et d'augmenter son immunité aux conducteurs primaires externes et voisins.

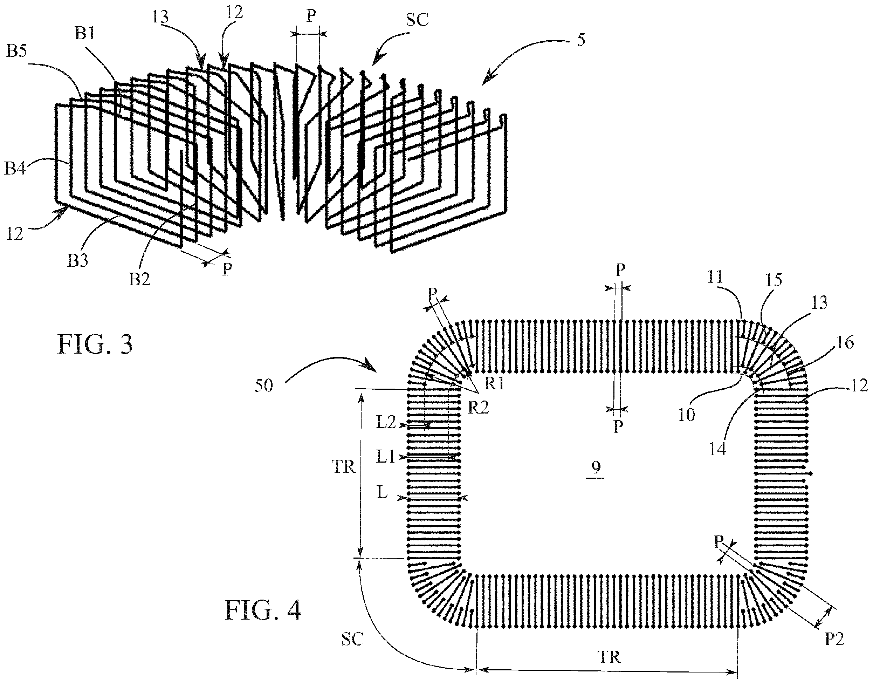

La figure 4 illustre une autre bobine électrique 50 du capteur de courant 1 qui est une variante de réalisation de la bobine électrique 5 de la figure 2. Les pièces identiques portent les mêmes références alphanumériques. Les secteurs circulaires SC étant définis par un arc intérieur 10 et un arc extérieur 11 de rayons Ri et Re inférieurs à ceux de la bobine électrique 5 de la figure 2, le pas P2 des spires principales 12 sur l'arc extérieur 11 est supérieur au pas P1 et sensiblement égal à 4P. Dans cette variante de réalisation, la bobine électrique 50 comporte, dans ses secteurs circulaires SC, des premières spires additionnelles 13 de largeur L1 et des secondes spires additionnelles 15 de largeur L2, les deux largeurs L1 et L2 étant différentes et inférieures à la largeur L des spires principales 12. Les premières spires additionnelles 13 s'étendent de l'arc extérieur 11 vers un premier arc intermédiaire 14 et les secondes spires additionnelles 15 s'étendent de l'arc extérieur 11 vers un second arc intermédiaire 16, les deux arcs intermédiaires 14, 16 étant disposés entre l'arc intérieur 10 et l'arc extérieur 11. Les premières et secondes spires additionnelles 13, 15 sont intercalées entre les spires principales 12 de telle sorte qu'une première spire additionnelle 13 encadrée par deux secondes spires additionnelles 15 sont positionnées entre deux spires principales 12 ramenant le pas entre deux spires 12, 13, 15 consécutives sur l'arc extérieur 11 sensiblement égal au pas P.

Les deux exemples de réalisation des bobines électriques 5 et 50 selon les figures 2 et 4 ne sont pas limitatifs et le nombre de spires additionnelles ainsi que leur largeur L1, L2 et/ou le nombre d'arcs intermédiaires 14, 16 dans les secteurs circulaires SC desdites bobines électriques ne sont pas restrictifs. Plus on ajoute d'arcs intermédiaires dans les secteurs circulaires SC, plus on dispose de liberté d'agencement des spires additionnelles pour atteindre une densité moyenne de spires constante.

D'une manière générale, les différentes largeurs L, L1, L2 des spires 12, 13, 15 sont déterminées de manière à minimiser la sensibilité du capteur de courant 1 à la position du conducteur primaire 2 ainsi qu'aux signaux parasites produits par un conducteur extérieur voisin. La détermination exacte des différentes largeurs L, L1, L2 est obtenue en calculant la réponse de la bobine électrique 5, 50 en fonction de la position d'un conducteur primaire 2 placé dans toutes les positions attendues, ainsi que la réponse de ladite bobine à un conducteur extérieur voisin placé au contact du capteur de courant 1 dans toutes les positions attendues et en minimisant à la fois l'écart de sensibilité par rapport à une position de référence du conducteur primaire 2 et par rapport à un conducteur extérieur. Dans le cadre de bobines électriques 5, 50 situées dans l'air de section rectangulaire et pour un conducteur primaire 2 circulaire, le calcul de la réponse de la bobine électrique 5, 50 peut-être effectué de manière analytique et de manière très précise, ce qui rend possible l'utilisation d'algorithmes d'optimisation pour la recherche du meilleur choix pour les différentes largeurs de spires L, L1, L2. D'une manière générale, l'optimum ainsi obtenu est proche d'une configuration dans laquelle la densité moyenne de spires prise sur toute la largeur de la bobine électrique 5, 50 dans les sections circulaires SC est identique à la densité de spires dans les tronçons rectilignes TR.

Les bobines électriques 5 et 50 telles que représentées dans les figures 2 et 4 comportant des spires additionnelles 13, 15 de largeur L1, L2 variable dans les secteurs circulaires SC ne peuvent être réalisées que sous la forme d'un circuit imprimé, et ne sont en aucun cas réalisables avec les technologies classiques de bobinage. A titre d'exemple non limitatif, pour les bobines électriques 5, 50 utilisant cette configuration de spires additionnelles 13, 15, les valeurs optimales des largeurs L1 et L2 sont dans ces exemples proches de L1=0,113xL et L2=0,31xL.

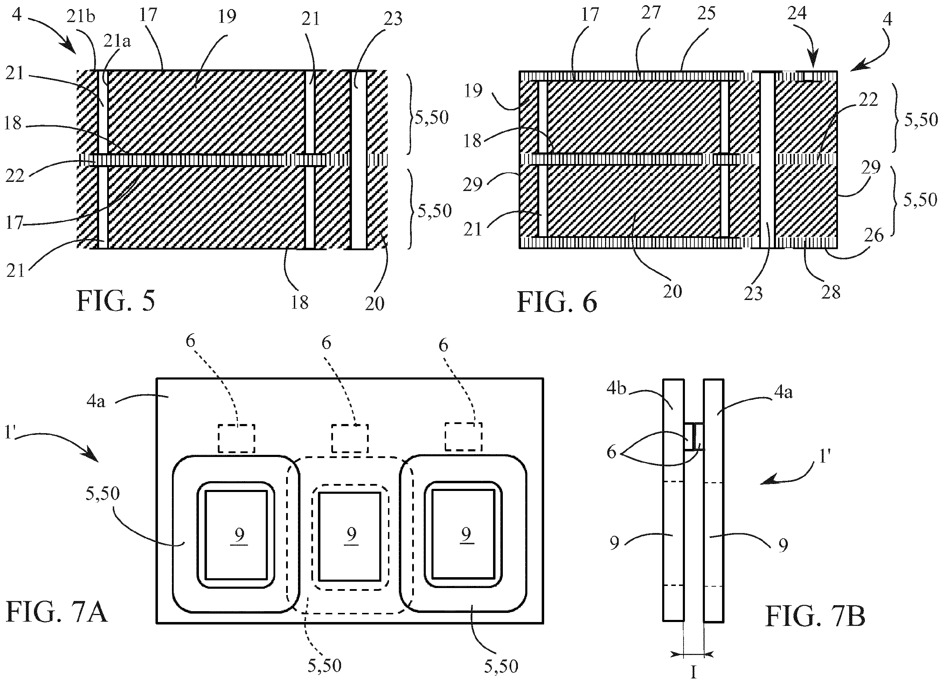

Les figures 5 et 6 illustrent une forme de réalisation du capteur de courant 1 comportant deux bobines électriques 5, 50 identiques et superposées, comme expliqué plus loin. Ces figures sont utilisées pour décrire la fabrication d'une des bobines électriques 5, 50, qui comporte deux couches conductrices 17, 18, appelées première couche conductrice 17 et deuxième couche conductrice 18, superposées et séparées entre elles par un cœur isolant 19 épais d'un substrat 20 faisant partie intégrante de la carte électronique 4. Le substrat 20 forme un support pour les couches conductrices 17, 18. Il est donc réalisé en matériau isolant, tel qu'à titre d'exemple une résine époxy, une résine polyimide, ou des matériaux à base de téflon. Les première et deuxième couches conductrices 17, 18 qui sont couramment réalisées en cuivre sont connectées entre elles par des premiers trous de liaison 21 traversant le cœur isolant 19 pour former les spires 12, 13, 15 de la bobine électrique 5, 50, ces trous de liaison 21 étant conducteurs. A cet effet, les trous de liaison 21 sont recouverts à l'intérieur d'un manchon conducteur 21a et entourés à l'extérieur d'une couronne conductrice 21b, notamment en cuivre.

La formation des spires 12, 13, 15 est illustrée plus en détail à la figure 3 qui montre un exemple de bobinage de la bobine électrique 5 dans un de ses secteurs circulaires SC sans représenter le substrat 20 de la carte électronique 4 pour faciliter la compréhension du dessin. Chaque spire 12, 13 qui correspond à un tour du bobinage comporte un premier brin rectiligne B1 prévu dans une des couches conductrices 17, 18, une première boucle de retour B2 traversant le substrat 20 par un premier trou de liaison 21 perpendiculaire au substrat 20, un second brin rectiligne B3 prévu dans l'autre des couches conductrices 17, 18, sensiblement parallèle au premier brin rectiligne B1, et une seconde boucle de retour B4 traversant le substrat 20 par un autre premier trou de liaison 21 perpendiculaire au substrat 20, puis un brin d'extrémité incliné B5 par rapport au premier brin rectiligne B1 de la spire 12, 13 suivante séparée de la spire 12, 13 précédente d'un pas P. Bien entendu, toute autre forme de réalisation du bobinage de la bobine électrique 5 peut convenir. Les avantages d'une telle réalisation sous la forme d'un circuit imprimé résident, comme on l'a vu précédemment, dans la régularité des spires 12, 13, 15 obtenues, dans la possibilité d'ajouter des spires additionnelles 13, 15 de largeurs différentes, dans la reproductibilité en série dudit bobinage, dans l'optimisation de ce bobinage et dans l'immunité de la bobine électrique 5, 50 obtenue vis-à-vis de la variation de la position du conducteur primaire 2 et des courants parasites générés par les conducteurs voisins. Il est ainsi possible de choisir un pas P le plus faible possible pour une technologie de circuit imprimé donnée dans les secteurs circulaires SC, qui est déployé dans les tronçons rectilignes TR dans le but de maximiser la sensibilité de mesure du capteur de courant 1, 1' obtenu A titre d'exemple non limitatif, pour des pistes conductrices d'une largeur de 150µm formant les spires 12 et les spires additionnelles 13, 15, et des trous de liaison 21 d'un diamètre minimum de 0.4mm pourvus d'une couronne conductrice 21b disposée autour des trous de liaison 21 d'une largeur minimale de 175µm, le pas P minimum est égal à 0.9mm.

Comme dans toutes les bobines de Rogowski, si on se contente de prélever la tension de sortie directement entre l'entrée de la première spire et la sortie de la dernière spire de la bobine électrique 5, 50, le capteur de courant 1 ne fonctionnera correctement que pour des conducteurs primaires 2 orthogonaux au plan de la bobine. Toute autre configuration créera des champs orthogonaux à la bobine électrique 5, 50 qui seront captés par toute la surface plane de la bobine. Pour résoudre ce problème, on peut utiliser un conducteur de retour (non représenté) présentant la même surface plane que la bobine électrique 5, 50 pour annuler cette réponse par effet différentiel. Dans une variante de réalisation simplifiée (non représentée), on peut utiliser un conducteur de retour ayant exactement le tracé de la projection de la bobine électrique 5, 50 sur le plan du circuit imprimé. Une telle configuration peut être obtenue au moyen d'un circuit imprimé à trois couches conductrices, le conducteur retour étant réalisé sur une troisième couche conductrice. Mais une telle configuration étant relativement rare, on la réalisera plutôt en quatre couches conductrices. Dans ce cas, le cœur isolant 19 épais du substrat 20 porte les première et deuxième couches conductrices 17, 18 de la bobine électrique 5, 50 et les troisième et quatrième couches conductrices externes forment le conducteur de retour. Ces troisième et quatrième couches conductrices externes sont séparées de la bobine électrique 5, 50 respectivement par une couche isolante mince du substrat 20. Ce conducteur de retour est ensuite connecté en série à la bobine électrique 5, 50 par des trous de liaison traversant le cœur isolant et les couches isolantes. Les termes « épais» et « mince» sont relatifs mais permettent d'identifier le cœur isolant 19 portant la bobine électrique 5, 50 du capteur de courant 1 qui est habituellement plus épais que les autres couches isolantes plus minces utilisées à d'autres fins. L'épaisseur des isolants dans les bobines électriques 5, 50 est choisie en fonction de la sensibilité recherchée. Plus l'isolant est épais et meilleur est le signal obtenu. Par contre, l'épaisseur des isolants entre les bobines électriques ou entre les bobines électriques et le blindage électrique est choisie la plus faible possible pour limiter l'encombrement global du capteur de courant 1, 1'.

Ce simple conducteur de retour n'est cependant pleinement efficace que pour des champs parasites homogènes. On peut améliorer l'immunité aux champs parasites orthogonaux en couplant deux bobines électriques 5, 50 identiques et en opposition, c'est-à-dire dont le bobinage est enroulé en sens inverse. Dans ce cas, les champs utiles s'ajoutent et, comme les deux bobines présentent la même sensibilité aux champs orthogonaux et sont couplées en opposition, ces champs parasites sont éliminés de manière quasi parfaite. Une telle configuration est avantageusement obtenue au moyen d'un circuit imprimé à quatre couches conductrices 17, 18 selon la figure 5. Chaque bobine électrique 5, 50 est réalisée par une première couche conductrice 17 et une deuxième couche conductrice 18 disposées de part et d'autre d'un cœur isolant 19 épais traversé par les premiers trous de liaison 21. Les deux bobines électriques 5, 50 sont superposées et séparées entre elles par une couche centrale isolante 22 mince et sont connectées en série par des deuxièmes trous de liaison 23 traversant le cœur isolant 19 et la couche centrale isolante 22.

Comme dans toutes les bobines de Rogowski, la bobine électrique 5, 50 est également sensible aux perturbations par couplage capacitif entre le conducteur primaire 2 sous tension véhiculant le courant alternatif à mesurer et la bobine électrique 5, 50. Pour éliminer cet effet, on dote le capteur de courant 1 d'un blindage électrique 24. En référence plus particulièrement à la figure 6, ce blindage électrique 24 peut consister en une couche conductrice supérieure externe 25 et une couche conductrice inférieure externe 26 recouvrant la ou les bobines électriques 5, 50 et/ou le conducteur de retour, et séparées de la ou des bobines électriques 5, 50 et/ou du conducteur électrique de retour respectivement par une couche isolante additionnelle 27, 28 mince du substrat 20. Ce blindage électrique peut être complété par au moins une couche conductrice latérale 29 recouvrant les tranches du substrat 20. La bobine électrique 5, 50 se trouve alors complètement enfermée dans une cage de Faraday et est de fait entièrement protégée des couplages capacitifs.

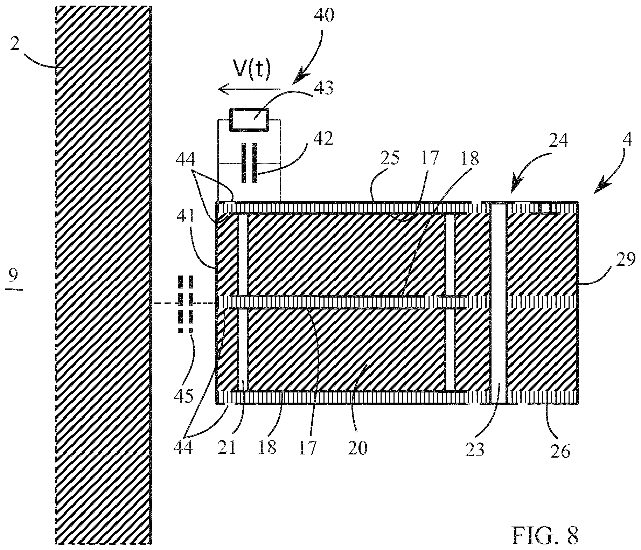

La figure 8 illustre une autre forme de réalisation du substrat 20 de la figure 6 permettant de compléter le capteur de courant 1, 1' de l'invention par un circuit de mesure de tension 40 agencé pour mesurer la tension V(t) appliquée au conducteur primaire 2. Dans cette forme de réalisation, la couche conductrice latérale 29 du substrat 20 de la figure 6, entourant la fenêtre de passage 9 prévue dans la bobine électrique 5, 50 pour le conducteur primaire 2, peut constituer une électrode de détection 41 de la tension appliquée audit conducteur primaire 2. Cette électrode de détection 41, au lieu d'être raccordée à un potentiel de référence comme celui du reste du blindage électrique 24, est isolée du reste du blindage électrique 24 et raccordée à un potentiel de référence, qui peut être le même que celui du blindage électrique 24 ou tout autre potentiel de référence non relié nécessairement au blindage, par un condensateur 42 raccordé en parallèle à une résistance 43. L'isolation électrique de l'électrode de détection 41 du reste du blindage électrique 24 est obtenue par une zone d'interruption 44 dans les couches conductrices correspondantes 17, 18, 25, 26 prévues sur le substrat 20, ou par tout autre moyen équivalent remplissant la même fonction. Le condensateur 42 peut présenter une valeur typique de quelques centaines picofarads (pF) à quelques dizaines nanofarads (nF), et la résistance 43 une valeur typique comprise entre quelques dizaines de kilo-ohms (kΩ) à quelques méga-ohms (MΩ). L'électrode de détection 41 et le conducteur primaire 2 forment ainsi une capacité illustrée par un condensateur 45 représenté en pointillés sur la figure 8 et d'une valeur comprise entre une fraction de picofarads et quelques picofarads (pF). L'ensemble formé par l'électrode de détection 41 et le montage RC (condensateur 42 + condensateur 45 + résistance 43) forme un filtre passe-haut d'une fréquence de coupure pouvant aller de quelques dixièmes de hertz à quelques centaines de hertz, selon le type de traitement choisi pour le signal de sortie. Ce filtre passe-haut forme également un diviseur de tension générant une tension de sortie V(t) aux bornes de la résistance 43 qui est une image de la tension appliquée audit conducteur primaire 2 pouvant être interprétée par une unité de traitement. Des exemples d'application sont illustrées dans les publications WO 2015/150670 A1 et WO 2015/150671 A1 du même demandeur. Les valeurs des condensateurs 42, 45 et de la résistance 43 ne sont données qu'à titre indicatif et ne sont pas limitatives.

Comme on est en présence d'une bobine de Rogowski à faible sensibilité, typiquement 10µV/A pour un courant à mesurer d'une fréquence de 50Hz, l'unité électronique de conditionnement 6, qui comprend en général un montage amplificateur passe-bas du 1er ordre, doit être disposée à proximité de la bobine électrique 5, 50 pour limiter les influences des champs magnétiques parasites dans les connexions entre la bobine électrique 5, 50 et ladite unité électronique de conditionnement 6. Une conséquence de cette proximité est la proximité du conducteur primaire 2 pouvant générer un couplage capacitif entre le conducteur primaire 2 et ladite unité électronique de conditionnement 6. Il est donc indispensable de protéger cette unité électronique de conditionnement 6 par un blindage électrique, qui peut être réalisé sous la forme d'un boîtier conducteur 30 enveloppant ladite unité électronique de conditionnement 6.

Le capteur de courant 1' peut également être un capteur polyphasé, c'est-à-dire adapté pour mesurer le courant alternatif dans une installation électrique comportant plus d'une phase, donc plus d'un conducteur primaire 2. Les figures 7A et 7B illustrent un exemple de réalisation d'un capteur de courant 1' triphasé. En fonction de l'entraxe des conducteurs primaires 2 et de l'encombrement des bobines électriques 5, 50, il peut être intéressant de prévoir un capteur de courant 1' pourvu de deux cartes électroniques 4a, 4b superposées, parallèles et séparées d'un intervalle I pour y disposer les bobines électriques 5, 50 de manière alternée. Par exemple, la bobine électrique 5, 50 qui correspond au conducteur primaire du milieu peut être disposée sur la carte électronique 4b arrière, tandis que les deux autres bobines électriques 5, 50 correspondant aux conducteurs primaires d'extrémité peuvent être disposées sur la carte électronique 4a avant. Ainsi, l'encombrement des bobines électriques 5, 50 n'est plus un obstacle et le capteur de courant 1' peut s'adapter à toutes les configurations d'appareil de mesure polyphasé et/ou d'installation électrique multiphasée. Dans cet exemple de réalisation, les unités électroniques de conditionnement 6 disposées à proximité de leurs bobines électriques 5, 50 seront positionnées dans l'intervalle I existant entre les deux cartes électroniques 4a, 4b. Ce montage particulier présente l'avantage de former intrinsèquement un blindage électrique protégeant lesdites unités électroniques de conditionnement 6, permettant de supprimer le boitier conducteur 30 nécessaire dans le capteur de courant 1 monophasé illustré à la figure 1 et ne comprenant qu'une seule carte électronique 4.

D'autres configurations peuvent être envisagées pour réaliser un capteur de courant 1' polyphasé selon l'invention. Les bobines électriques 5 et les fenêtres de passage 9 correspondantes peuvent être disposées sur une même carte électronique 4. Dans ce cas, elles peuvent être alignées, en quinconce ou selon une disposition quelconque.

### Possibilités d'application industrielle :

Le capteur de courant 1, 1' qui vient d'être décrit est par conséquent réalisable par des techniques de fabrication des circuits imprimés bien connues permettant de réaliser des bobines électriques de type Rogowski de forme sensiblement polygonale et d'optimiser la qualité de ces bobines leur offrant une immunité aux champs et courants parasites, équivalente aux bobines circulaires, en ayant les avantages de la forme polygonale en termes d'encombrement et de facilité d'implantation. Il ressort clairement de cette description que l'invention permet d'atteindre les buts fixés.

La présente invention n'est toutefois pas limitée aux exemples de réalisation décrits mais s'étend à toute modification et variante évidentes pour un homme du métier, dans le cadre des revendications annexées.

## Revendications

1. Capteur de courant (1, 1') pour mesurer un courant alternatif, ledit capteur comportant au moins une bobine électrique (5, 50), une unité électronique de conditionnement (6) du signal de ladite bobine électrique et un bornier de raccordement électrique (7), ladite bobine électrique (5, 50) ayant un contour fermé s'inscrivant dans un polygone et délimitant en son centre une fenêtre de passage (9) pour un conducteur électrique traversé par le courant alternatif à mesurer, ce conducteur étant appelé conducteur primaire (2), ladite bobine électrique (5, 50) comportant N tronçons rectilignes (TR) de largeur L et N secteurs circulaires (SC) délimités chacun par un arc intérieur (10) de rayon intérieur Ri et un arc extérieur (11) de rayon extérieur Re, lesdits tronçons rectilignes (TR) étant reliés deux à deux par un secteur circulaire (SC), lesdits tronçons rectilignes (TR) étant constitués de spires (12) séparées entre elles d'un pas P constant, ladite bobine électrique (5, 50) comportant en outre, dans lesdits secteurs circulaires (SC), des spires additionnelles (13, 15) de largeur (L1, L2) inférieure à la largeur des autres spires, appelées spires principales (12), et s'étendant dudit arc extérieur (11) vers au moins un arc intermédiaire (14, 16) disposé entre ledit arc intérieur (10) et ledit arc extérieur (11), lesdites spires additionnelles (13, 15) étant intercalées entre lesdites spires principales (12), **caractérisé en ce que** ladite bobine électrique (5, 50) est réalisée sous la forme d'un circuit imprimé prévu sur au moins une carte électronique (4), **en ce que** les N tronçons rectilignes (TR) et les N secteurs circulaires (SC) ont une même largeur (L), **en ce que** dans lesdits tronçons circulaires (SC), les spires principales (12) sont séparées entre elles sur ledit arc intérieur (10) d'un pas constant égal au pas P desdits tronçons rectilignes (TR) d'une part, et les spires principales (12) et additionnelles (13, 15) sont séparées entre elles sur ledit arc extérieur (11) d'un pas sensiblement égal au pas P desdits tronçons rectilignes (TR) d'autre part, de sorte que la densité moyenne de spires est quasi constante dans toute ladite bobine électrique (5, 50), et **en ce que** ledit pas P constant est choisi le plus faible possible, pour une technologie de circuit imprimé donnée, dans lesdits secteurs circulaires (SC) et est déployé dans lesdits tronçons rectilignes (TR) de sorte à maximiser la sensibilité de mesure dudit capteur de courant (1, 1').

2. Capteur de courant selon la revendication 1, **caractérisé en ce que** ladite bobine électrique (5) comporte, dans ses secteurs circulaires (SC), des premières spires additionnelles (13) de largeur (L1) s'étendant dudit arc extérieur (11) vers respectivement un premier arc intermédiaire (14) disposé entre ledit arc intérieur (10) et ledit arc extérieur (11).

3. Capteur de courant selon la revendication 1, **caractérisé en ce que** ladite bobine électrique (50) comporte, dans ses secteurs circulaires (SC), des premières spires additionnelles (13) et des secondes spires additionnelles (15) de largeurs respectives (L1) et (L2) différentes s'étendant dudit arc extérieur (11) vers respectivement un premier arc intermédiaire (14) et un second arc intermédiaire (16) disposés entre ledit arc intérieur (10) et ledit arc extérieur (11).

4. Capteur de courant selon la revendication 1, **caractérisé en ce que** ladite bobine électrique (5, 50) est réalisée sous la forme d'un circuit imprimé comportant au moins une première couche conductrice (17) et une deuxième couche conductrice (18), superposées, séparées entre elles par un cœur isolant (19) d'un substrat (20) de ladite carte électronique (4), et **en ce que** lesdites première et deuxième couches conductrices (17, 18) sont connectées entre elles par des trous de liaison (21) traversant ledit substrat (20) pour former les spires (12, 13, 15) de ladite bobine électrique (5, 50).

5. Capteur de courant selon la revendication 4, **caractérisé en ce qu'**il comporte un conducteur de retour présentant une surface plane sensiblement égale à celle de ladite bobine électrique (5, 50) pour annuler des champs parasites, ledit conducteur de retour étant réalisé sous la forme d'un circuit imprimé comportant au moins une troisième couche conductrice, superposée à ladite bobine électrique (5, 50) et séparée d'elle par une couche isolante dudit substrat (20), ledit conducteur de retour étant connecté en série à ladite bobine électrique (5, 50) par des trous de liaison traversant ledit substrat (20).

6. Capteur de courant selon la revendication 4, **caractérisé en ce qu'**il comporte deux bobines électriques (5, 50) réalisées sous la forme d'un circuit imprimé comportant au moins quatre couches conductrices (17, 18), lesdites bobines électriques (5, 50) étant identiques, opposées, superposées, séparées entre elles par une couche centrale isolante (22) du substrat, et connectées en série par des trous de liaison (23) traversant ledit substrat (20).

7. Capteur de courant selon l'une quelconque des revendications précédentes, **caractérisé en ce qu'**il comporte un blindage électrique (24).

8. Capteur de courant selon la revendication 7, **caractérisé en ce que** ledit blindage électrique (24) comporte au moins une couche conductrice supérieure externe (25) et une couche conductrice inférieure externe (26) recouvrant ladite bobine électrique (5, 50) et son conducteur de retour, ou lesdites bobines électriques (5, 50), et séparées de la ou des bobines électriques (5, 50) et/ou du conducteur de retour par une couche isolante additionnelle (27, 28) dudit substrat (20).

9. Capteur de courant selon la revendication 7, **caractérisé en ce que** ledit blindage électrique (24) comporte en outre au moins une couche conductrice latérale (29) recouvrant la tranche dudit substrat (20).

10. Capteur de courant selon la revendication 7, **caractérisé en ce que** ledit blindage électrique (24) comporte en outre un boîtier conducteur (30) disposé autour de ladite unité électronique de conditionnement (6).

11. Capteur de courant selon l'une quelconque des revendications précédentes, **caractérisé en ce qu'**il est monophasé et comporte une fenêtre de passage (9) pour un conducteur primaire (2), ladite fenêtre de passage (9) étant entourée d'au moins une bobine électrique (5, 50).

12. Capteur de courant selon l'une quelconque des revendications 1 à 10, **caractérisé en ce qu'**il est polyphasé et comporte N fenêtres de passage (9) pour N conducteurs primaires (2), chaque fenêtre de passage (9) étant entourée d'au moins une bobine électrique (5, 50).

13. Capteur de courant selon la revendication 12, **caractérisé en ce qu'**il comporte une carte électronique (4), comportant N fenêtres de passage (9), et **en ce que** lesdites bobines électriques (5, 50) correspondantes sont disposées sur ladite carte électronique (4).

14. Capteur de courant selon la revendication 12, **caractérisé en ce qu'**il comporte au moins deux cartes électroniques (4a, 4b) superposés, comportant chacune N fenêtres de passage (9), et **en ce que** lesdites bobines électriques (5, 50) correspondantes sont réparties alternativement sur lesdites cartes électroniques (4a, 4b).

15. Capteur de courant selon la revendication 14, **caractérisé en ce que** l'unité électronique de conditionnement (6) associée à chaque bobine électrique (5, 50) est disposée dans l'intervalle (I) situé entre les deux cartes électroniques (4), formant intrinsèquement un blindage électrique protégeant lesdites unités électroniques de conditionnement (6).

16. Capteur de courant selon l'une quelconque des revendications précédentes, **caractérisé en ce qu'**il comporte en outre un circuit de mesure de tension (40) agencé pour mesurer la tension appliquée audit conducteur primaire (2).

17. Capteur de courant selon la revendication 16, **caractérisé en ce que** ledit circuit de mesure de tension (40) comporte au moins une électrode de détection (41) entourant la fenêtre de passage (9) prévue dans ladite bobine électrique (5, 50), ladite électrode de détection (41) étant raccordée à un potentiel de référence par un circuit RC (42, 43, 45) et étant constituée d'au moins une couche conductrice latérale (29) recouvrant la tranche du substrat (20) entourant ladite fenêtre de passage (9).

## Patentansprüche

1. Stromsensor (1, 1') zur Messung eines Wechselstrom, dieser Sensor enthält mindestens eine elektrische Spule (5, 50), eine elektronische Einheit (6) zur Aufbereitung des Signals dieser elektrischen Spule sowie eine elektrische Anschlussleiste (7), diese elektrische Spule (5, 50) hat eine geschlossene Kontur, innerhalb eines Polygons, in dessen Zentrum ein Durchgangsfenster (9) für einen elektrischen Leiter, durch den der zu messende Wechselstrom fließt, umgrenzt ist, dieser Leiter wird Primärleiter (2) genannt, die erwähnte elektrische Spule (5, 50) enthält dabei N geradlinige Segmente (TR), mit einer Breite L und N Kreissektoren (SC), die jeweils von einem Innenbogen (10) mit einem Innenradius Ri und einem Außenbogen (11) mit einem Außenradius Re begrenzt werden, jeweils zwei dieser geradlinigen Segmente (TR) sind über einen Kreissektor (SC) verbunden, diese geradlinigen Segmente (TR) bestehen aus Windungen (12) die voneinander durch einen konstanten Abstand P getrennt sind, diese elektrische Spule (5, 50) enthält außerdem in den erwähnten Kreissektoren (SC), zusätzliche Windungen (13, 15) mit einer Breite (L1, L2), die kleiner ist als die Breite der anderen Windungen, die Hauptwindungen (12) genannt werden und die vom erwähnten Außenbogen (11) zu mindestens einem Zwischenbogen (14, 16) verlaufen, der zwischen diesem Innenbogen (10) und diesem Außenbogen (11) angeordnet ist, diese zusätzlichen Windungen (13, 15) sind zwischen den erwähnten Hauptwindungen (12) eingefügt, **dadurch gekennzeichnet, dass** diese elektrische Spule (5, 50) ausgeführt wird in der Form einer gedruckte Schaltung, vorgesehen auf mindestens einer elektronische Platine (4), dadurch, dass die N geradlinigen Segmente (TR) und die N Kreissektoren (SC) dieselbe Breite (L) haben, dadurch, dass in den Kreissektoren (SC), einerseits die Hauptwindungen (12) auf dem erwähnten Innenbogen (10) voneinander durch einen Abstand gleich dem Abstand P dieser geradlinige Segmente (TR) getrennt sind, und andererseits die Haupt- (12) und zusätzlichen Windungen (13, 15) voneinander auf diesem Außenbogen (11) durch einem Abstand getrennt sind, der im Wesentlichen dem Abstand P dieser geradlinigen Segmente (TR) entspricht, so dass die mittlere Dichte der Windungen in der gesamten elektrischen Spule (5, 50) praktisch konstant ist, und dass der erwähnte konstante Abstand P in den erwähnten Kreissektoren (SC) so klein wie möglich gewählt wird, für eine gegebene gedruckte Schaltungstechnologie, und sich in den erwähnten geradlinigen Segmenten (TR) entfaltet, um die Messsensibilität dieses Stromsensors (1, 1') zu maximieren.

2. Stromsensor nach Anspruch 1, **dadurch gekennzeichnet, dass** die erwähnte elektrische Spule (5) in ihren Kreissektoren (SC), erste zusätzliche Windungen (13) mit einer Breite (L1) enthält, die vom erwähnten Außenbogen (11) jeweils zu einem ersten Zwischenbogen (14), angeordnet zwischen dem erwähnten Innenbogen (10) und dem erwähnten Außenbogen (11), verlaufen.

3. Stromsensor nach Anspruch 1, **dadurch gekennzeichnet, dass** die erwähnte elektrische Spule (50) in ihren Kreissektoren (SC), erste zusätzliche Windungen (13) und zweite zusätzliche Windungen (15) mit einer jeweils unterschiedlichen Breite (L1) und (L2) enthält, die vom erwähnten Außenbogen (11) zu jeweils einem ersten Zwischenbogen (14) und einem zweiten Zwischenbogen (16), angeordnet zwischen dem erwähnten Innenbogen (10) und dem erwähnten Außenbogen (11), verlaufen.

4. Stromsensor nach Anspruch 1, **dadurch gekennzeichnet, dass** die erwähnte elektrische Spule (5, 50) in der Form einer gedruckten Schaltung ausgeführt ist, die mindestens eine erste leitende Schicht (17) enthält, und eine zweite, darüber gelegte leitende Schicht (18), die voneinander durch einen Isolierkern (19) aus einem Substrat (20) dieser elektronischen Platine (4) getrennt sind, und dadurch, dass die erste und zweite leitende Schicht (17, 18) miteinander durch Verbindungslöcher (21) verbunden sind, die durch das Substrat (20) hindurchführen, um die Windungen (12, 13, 15) der erwähnten elektrischen Spule (5, 50) zu bilden.

5. Stromsensor nach Anspruch 4, **dadurch gekennzeichnet, dass** er einen Rückleiter enthält, der eine plane Oberfläche aufweist, die im Wesentlichen gleich der der elektrischen Spule (5, 50) ist, um Störfelder auszugleichen, dieser Rückleiter wird in der Form einer gedruckten Schaltung ausgeführt, mit mindestens einer dritten leitenden Schicht, die über die erwähnte elektrische Spule (5, 50) gelegt ist und von ihr durch eine Isolierschicht aus dem erwähnten Substrat (20) getrennt, dieser Rückleiter ist in Reihe mit der elektrischen Spule (5, 50) geschaltet durch Verbindungslöcher, die durch dieses Substrat (20) hindurchführen.

6. Stromsensor nach Anspruch 4, **dadurch gekennzeichnet, dass** er zwei elektrische Spulen (5, 50) enthält, ausgeführt in der Form einer gedruckten Schaltung, mit mindestens vier leitenden Schichten (17, 18), diese elektrischen Spulen (5, 50) sind identisch, entgegengesetzt, übereinander gelegt, voneinander getrennt durch eine zentrale Isolierschicht (22) des Substrats und in Reihe verbunden durch Verbindungslöcher, die durch dieses Substrat (20) hindurchführen.

7. Stromsensor nach irgendeinem der vorangehenden Ansprüche, **dadurch gekennzeichnet, dass** er eine elektrische Abschirmung (24) enthält.

8. Stromsensor nach Anspruch 7, **dadurch gekennzeichnet, dass** diese elektrische Abschirmung (24) mindestens eine externe obere leitende Schicht (25) sowie eine externe untere leitende Schicht (26) enthält, die diese elektrische Spule (5, 50) bedeckt und seinen Rückleiter, oder diese elektrischen Spulen (5, 50), und von der oder den elektrischen Spulen(n) (5, 50) und/oder dem Rückleiter durch eine zusätzliche Isolierschicht (27, 28) dieses Substrats (20) getrennt.

9. Stromsensor nach Anspruch 7, **dadurch gekennzeichnet, dass** diese elektrische Abschirmung (24) außerdem mindestens eine seitliche leitende Schicht (29) enthält, die den Abschnitt dieses Substrats (20) bedeckt.

10. Stromsensor nach Anspruch 7, **dadurch gekennzeichnet, dass** diese elektrische Abschirmung (24) außerdem ein leitendes Gehäuse (30) umfasst, angeordnet um diese elektronische Aufbereitungseinheit (6) herum.

11. Stromsensor nach irgendeinem der vorangehenden Ansprüche, **dadurch gekennzeichnet, dass** er einphasig ist und ein Durchgangsfenster (9) für einen Primärleiter (2) enthält, dieses Durchgangsfenster (9) wird von mindestens einer elektrischen Spule (5, 50) umgeben.

12. Stromsensor nach irgendeinem der Ansprüche 1 bis 10, **dadurch gekennzeichnet, dass** er mehrphasig ist und N Durchgangsfenster (9) für N Primärleiter (2) enthält, jedes Durchgangsfenster (9) wird von mindestens einer elektrischen Spule (5, 50) umgeben.

13. Stromsensor nach Anspruch 12, **dadurch gekennzeichnet, dass** er eine elektronische Platine (4) enthält, mit N Durchgangsfenstern (9), und dadurch, dass die entsprechenden elektrischen Spulen (5, 50) auf dieser elektronischen Platine (4) angeordnet sind.

14. Stromsensor nach Anspruch 12, **dadurch gekennzeichnet, dass** er mindestens zwei übereinander gelegte elektronische Platinen (4a, 4b) enthält, mit N Durchgangsfenstern (9), und dadurch, dass die entsprechenden elektrischen Spulen (5, 50) alternativ auf diesen elektronischen Platinen (4a, 4b) angeordnet sind.

15. Stromsensor nach Anspruch 14, **dadurch gekennzeichnet, dass** die elektronische Aufbereitungseinheit (6), die mit jeder elektrischen Spule (5, 50) verbunden ist, im Intervall (I) zwischen den beiden elektronischen Platinen (4) angeordnet ist, die eine intrinsische Abschirmung bilden, die diese elektronischen Aufbereitungseinheiten (6) schützt.

16. Stromsensor nach irgendeinem der vorangehenden Ansprüche, **dadurch gekennzeichnet, dass** er außerdem einen Spannungsmesskreis (40) enthält, vorgesehen zur Messung der an den erwähnten Primärleiter (2) angelegten Spannung.

17. Stromsensor nach Anspruch 16, **dadurch gekennzeichnet, dass** der erwähnte Spannungsmesskreis (40) mindestens eine Messelektrode (41) enthält, die das Durchgangsfenster (9) umgibt, dass in dieser elektrischen Spule (5, 50) vorgesehen ist, diese Messelektrode (41) ist dabei über einen RC- Kreis (42, 43, 45) mit einem Bezugspotential verbunden, das aus mindestens einer seitlichen leitenden Schicht (29) besteht, die den Substratabschnitt (20) bedeckt, der dieses Durchgangsfenster (9) umgibt.

## Claims

1. Current sensor (1, 1') for measuring an alternating current, said sensor comprising at least one electrical coil (5, 50), an electronic unit (6) for conditioning the signal of said electrical coil and an electrical terminal block (7), said electrical coil (5, 50) having a closed contour inscribed within a polygon and delimiting in its center a through window (9) for an electrical conductor crossed by the alternating current to be measured, this conductor being called primary conductor (2), said electrical coil (5, 50) comprising N rectilinear segments (TR) of width L and N circular sectors (SC) delimited each by an interior arc (10) of interior radius Ri and an exterior arc (11) of exterior radius Re, said rectilinear segments (TR) being connected two by two by a circular sector (SC), said rectilinear segments (TR) being made of turns (12) separated from each other by a constant spacing P, said electrical coil (5, 50) moreover comprising, in its circular sectors (SC), additional turns (13, 15) with a width (L1, L2) lower than the width of the other turns, called main turns (12), and extending from said exterior arc (11) towards at least one intermediate arc (14, 16) located between said interior arc (10) and said exterior arc (11), said additional turns (13, 15) being inserted between said main turns (12), **characterized in that** said electrical coil (5, 50) is made in the form of a printed circuit provided on at least one electronic board (4), **in that** the N rectilinear segments (TR) and the N circular sectors (SC) have the same width L, **in that** in said circular sectors (SC), the main turns (12) are separated from each other on said interior arc (10) by a constant spacing equal to spacing P of said rectilinear segments (TR) on the one hand, and the main turns (12) and the additional turns (13, 15) are separated from each other on said exterior arc (11) by a spacing substantially equal to spacing P of said rectilinear segments (TR) on the other hand, in order that the average turns density is almost constant in all the said electrical coil (5, 50), and **in that** the said constant spacing P is chosen the smallest possible, for a given printed circuit technology, in said circular sectors (SC) and is implemented in said rectilinear segments (TR) in order to maximize the measuring sensitivity of said current sensor (1, 1').

2. Current sensor according to claim 1, **characterized in that** said electrical coil (5) comprises, in its circular sectors (SC), first additional turns (13) with a width (L1) extending from said exterior arc (11) towards respectively a first intermediate arc (14) located between said interior arc (10) and said exterior arc (11).

3. Current sensor according to claim 1, **characterized in that** said electrical coil (50) comprises, in its circular sectors (SC), first additional turns (13) and second additional turns (15) with different respective widths (L1) and (L2) extending from said exterior arc (11) towards respectively a first intermediate arc (14) and a second intermediate arc (16) located between said interior arc (10) and said exterior arc (11).

4. Current sensor according to claim 1, **characterized in that** said electrical coil (5, 50) is made in the form of a printed circuit comprising at least a first conductive layer (17) and a second conductive layer (18), superimposed on each other, separated from each other by an insulating core (19) of a substrate (20) of said electronic board (4), and **in that** said first and second conductive layers (17, 18) are connected to each other by means of connecting holes (21) passing through said substrate (20) to form the turns (12, 13, 15) of said electrical coil (5, 50).

5. Current sensor according to claim 4, **characterized in that** it comprises a return conductor having a flat surface substantially equal to that of said electrical coil (5, 50) to cancel interference fields, said return conductor being made in the form of a printed circuit comprising at least a third conductive layer, superimposed on said electrical coil (5, 50) and separated from it by an insulating layer of said substrate (20), said return conductor being serially connected to said electrical coil (5, 50) by means of connecting holes passing through said substrate (20).

6. Current sensor according to claim 4, **characterized in that** it comprises two electrical coils (5, 50) made in the form of a printed circuit comprising at least four conductive layers (17, 18), said electrical coils (5, 50) being identical, opposite to and superimposed on each other, separated from each other by a central insulating layer (22) of the substrate, and serially connected by means of connecting holes (23) passing through said substrate (20).

7. Current sensor according to any of the previous claims, **characterized in that** it comprises an electrical shield (24).

8. Current sensor according to claim 7, **characterized in that** said electrical shield (24) includes at least one upper exterior conductive layer (25) and one lower exterior conductive layer (26) covering said electrical coil (5, 50) and its return conductor, or said electrical coils (5, 50), and separated from the electrical coil(s) (5, 50) and/or from the return conductor by means of an additional insulating layer (27, 28) of said substrate (20).

9. Current sensor according to claim 7, **characterized in that** said electrical shield (24) moreover comprises at least one lateral conductive layer (29) covering the edge of said substrate (20).

10. Current sensor according to claim 7, **characterized in that** said electrical shield (24) moreover comprises a conductive housing (30) arranged around said electronic conditioning unit (6).

11. Current sensor according to any of the previous claims, **characterized in that** it is single-phase and comprises a through window (9) for a primary conductor (2), said through window (9) being surrounded by at least one electrical coil (5, 50).

12. Current sensor according to any of claims 1 to 10, **characterized in that** it is polyphase and comprises N through windows (9) for N primary conductors (2), each through window (9) being surrounded by at least one electrical coil (5, 50).

13. Current sensor according to claim 12, **characterized in that** it comprises one electronic board (4), provided with N through windows (9), and **in that** said corresponding electrical coils (5, 50) are arranged on said electronic board (4).

14. Current sensor according to claim 12, **characterized in that** it comprises at least two superimposed electronic boards (4a, 4b), comprising each N through windows (9), and **in that** said corresponding electrical coils (5, 50) are distributed alternately on said electronic boards (4a, 4b).

15. Current sensor according to claim 14, **characterized in that** electronic conditioning unit (6) associated to every electrical coil (5, 50) is arranged in the interval (I) located between the two electronic boards (4), forming intrinsically an electrical shield protecting said electronic conditioning units (6).

16. Current sensor according to any of the previous claims, **characterized in that** it moreover comprises a voltage measuring circuit (40) arranged for measuring the voltage applied to said primary conductor (2).

17. Current sensor according to claim 16, **characterized in that** said voltage measuring circuit (40) comprises at least one detection electrode (41) surrounding the through window (9) provided in said electrical coil (5, 50), said detection electrode (41) being connected to a reference potential by a RC circuit (42, 43, 45) and being made of at least one lateral conductive layer (29) covering the edge of substrate (20) surrounding said through window (9).
